# EUROPEAN PATENT APPLICATION

(11) **EP 4 796 881 A1**
(43) Date of publication of application: **26.08.2026**
(21) Application number: 24899580.5
(22) Date of filing: 14.11.2024
(51) Int. Cl.: F27D 1/18, F27B 1/10, H01L 21/67, E05F 5/06

(54) **FURNACE DOOR DRIVING DEVICE AND SEMICONDUCTOR HEAT TREATMENT APPARATUS**

(30) Priority: 07.12.2023 CN 202311675317
(71) Applicant: Beijing NAURA Microelectronics Equipment Co., Ltd., Beijing 100176 (CN)
(72) Inventor: LI, Hongli, Beijing 100176 (CN)
(74) Representative: Cohausz & Florack
(86) International application number: PCT/CN2024/131943
(87) International publication number: WO 2025/118938

(57) **Abstract**

There are provided a furnace door driving device and a semiconductor heat treatment apparatus. The furnace door driving device includes a connecting disk (1), a limiting assembly (2), a stop assembly (3), and a driving source (4); the driving source (4) is configured to drive the connecting disk (1) to rotate around an axis of the connecting disk (1); the connecting disk (1) is connected to a furnace door (02) for driving the furnace door (02) to rotate; the connecting disk (1) is provided with a limiting part (13) and a stop part (14); and the limiting assembly (2) is configured to be in limiting fit with the limiting part (13) when the connecting disk (1) rotates to a preset limit position, so as to stop the connecting disk (1) from rotating continuously in an original rotation direction; and the stop assembly (3) is configured to be in stop fit with the stop part (14) when the limiting assembly (2) is in limiting fit with the limiting part (13), so as to prevent the connecting disk (1) from rotating in a direction opposite to the original rotation direction. Thus, reverse rotation of the furnace door (02) is prevented, and severe vibration of the connecting disk (1) caused by repeated limiting fit between the connecting disk (1) and the limiting assembly (2) is avoided, thereby avoiding damage to the furnace door (02) caused by excessive vibration of the furnace door (02).

## Description

### TECHNICAL FIELD

The present disclosure belongs to the field of semiconductor process equipment, and particularly relates to a furnace door driving device and a semiconductor heat treatment apparatus.

### BACKGROUND

A furnace door is an important part for separating a chamber of a vertical furnace equipment from a microenvironment. Specifically, the furnace door mainly performs a function of thermal insulation to prevent heat inside the chamber from being directly transferred to the microenvironment, thereby protecting electrical components inside the microenvironment. In the existing technology, a furnace door driving device is generally adopted to drive the furnace door to rotate, so as to control the furnace door to reach or move away from a chamber outlet position.

The existing furnace door driving device generally includes a connecting disk connected to the furnace door and two stop blocks fixed on a circumferential side of the connecting disk. When the connecting disk rotates to a specified position, protrusions on circumferential side of the connecting disk may strike the stop blocks to stop the rotation of the connecting disk. However, after the rotation is stopped, the furnace door rebounds for a plurality of times due to excessive inertia, such that a surface of the furnace door vibrates severely, which causes a quartz plate forming a main body of the furnace door to break, and may further cause damage to parts inside the furnace door.

### SUMMARY

The present disclosure at least partially solves the problem that the furnace door of the existing semiconductor heat treatment apparatus is damaged due to excessive vibration of the furnace door when the furnace door is closed, and provides a furnace door driving device and a semiconductor heat treatment apparatus.

An embodiment of the present disclosure provides a furnace door driving device for a semiconductor heat treatment apparatus to drive a furnace door of the semiconductor heat treatment apparatus to rotate, including: a connecting disk, a limiting assembly, a stop assembly, and a driving source;
the driving source is connected to the connecting disk, and is configured to drive the connecting disk to rotate around an axis of the connecting disk;
the connecting disk is connected to the furnace door, and is configured to drive the furnace door to rotate; the connecting disk is provided with a limiting part and a stop part; and the limiting assembly is configured to be in limiting fit with the limiting part when the connecting disk rotates to a preset limit position, so as to stop the connecting disk from rotating continuously in an original rotation direction; and
the stop assembly is configured to be in stop fit with the stop part when the limiting assembly is in limiting fit with the limiting part, so as to prevent the connecting disk from rotating in a direction opposite to the original rotation direction.

In some embodiments, the original rotation direction is a first rotation direction or a second rotation direction opposite to the first rotation direction;
the stop part includes a gear structure; and
the stop assembly is configured to abut against the gear structure when the connecting disk rotates in the second rotation direction, and disengage from the gear structure when the connecting disk rotates in the first rotation direction; or, the stop assembly is configured to abut against the gear structure when the connecting disk rotates in the first rotation direction, and disengage from the gear structure when the connecting disk rotates in the second rotation direction.

In some embodiments, the stop assembly includes a switching assembly, and a first stop assembly and a second stop assembly which are fixed on the periphery of the connecting disk; wherein
the switching assembly is configured to switch the first stop assembly to a stop state and switch the second stop assembly to a non-stop state when the connecting disk rotates in the first rotation direction, and is further configured to switch the second stop assembly to the stop state and switch the first stop assembly to the non-stop state when the connecting disk rotates in the second rotation direction;
wherein the non-stop state is a state in which the first stop assembly or the second stop assembly is away from the gear structure; and the stop state is a state in which the first stop assembly or the second stop assembly is in driving fit with the gear structure when the connecting disk rotates in the original rotation direction, and abuts against the gear structure when the connecting disk rotates in the direction opposite to the original rotation direction.

In some embodiments, each of the first stop assembly and the second stop assembly includes: an extendable structure, which is provided with an extendable end; the extendable end is kept extended when subjected to no external force, so as to keep the corresponding first stop assembly or the corresponding second stop assembly in the stop state; and
the switching assembly is configured to drive the extendable end of the second stop assembly to retract to a position away from the connecting disk when the connecting disk rotates in the first rotation direction, so as to switch the second stop assembly to the non-stop state; and the switching assembly is further configured to drive the extendable end of the first stop assembly to retract to a position away from the connecting disk when the connecting disk rotates in the second rotation direction, so as to switch the first stop assembly to the non-stop state.

In some embodiments, the extendable end of the first stop assembly and the extendable end of the second stop assembly are located on two sides of the connecting disk, respectively;
the extendable end of the first stop assembly is capable of extending and retracting in a first linear direction; and the first linear direction meets the condition that the gear structure is capable of pushing the extendable end to retract when the connecting disk rotates in the first rotation direction and abutting against a tooth flank of a corresponding gear tooth in the gear structure when the connecting disk rotates in the second rotation direction; and
the extendable end of the second stop assembly is capable of extending and retracting in a second linear direction; and the second linear direction meets the condition that the gear structure is capable of pushing the extendable end to retract when the connecting disk rotates in the second rotation direction and abutting against a tooth flank of a corresponding gear tooth in the gear structure when the connecting disk rotates in the first rotation direction.

In some embodiments, each of the first stop assembly and the second stop assembly further includes a fixed structure; and two fixed structures are respectively fixed on the periphery of the connecting disk;
the extendable structure further includes a mating block serving as the extendable end, a spring, and a spring pin;
the spring pin of the first stop assembly extends in the first linear direction; the spring pin of the second stop assembly extends in the second linear direction; and one end of the spring pin is fixedly connected to the mating block, and the other end of the spring pin is connected to the fixed structure and is in sliding fit with the fixed structure; and the spring is sleeved on the spring pin, and two ends of the spring are connected to the corresponding fixed structure and the corresponding mating block, respectively.

In some embodiments, the mating block has a first surface; and the first surface is parallel to an extension direction of the corresponding spring pin, and is capable of abutting against a tooth flank of an adjacent gear tooth.

In some embodiments, the limiting part includes a limiting protrusion, which protrudes from an outer circumferential surface of the connecting disk; and
the limiting assembly includes two limiting blocks, which are fixed on the periphery of the connecting disk, and the two limiting blocks are respectively configured to stop the limiting protrusion from continuously moving when the connecting disk rotates to preset limit positions in the first rotation direction and the second rotation direction, so as to stop the connecting disk from continuously rotating.

In some embodiments, the switching assembly includes a rotary motor and a cam; and a power output end of the rotary motor is connected to the cam, and is configured to drive the cam to rotate; and
the cam is located between the first stop assembly and the second stop assembly; and the cam is configured to push one of two extendable ends away from the connecting disk, so as to drive the first stop assembly or the second stop assembly to switch to the non-stop state.

In some embodiments, the furnace door driving device further includes a stationary disk with a fixed position, and a bearing; and the stationary disk is provided with a bearing support, which is configured to be fixedly connected to an inner ring of the bearing;
the connecting disk includes a first sub-connecting disk and a second sub-connecting disk coaxially disposed; the gear structure is formed on an outer circumferential side of the first sub-connecting disk; and the first sub-connecting disk is provided with a bearing mounting hole, which is configured to be connected to an outer ring of the bearing; and the second sub-connecting disk is located on a side of the first sub-connecting disk away from the stationary disk, and is fixedly connected to the first sub-connecting disk; and the limiting part is disposed on an outer circumferential side of the second sub-connecting disk.

As another technical solution, the present disclosure further provides a semiconductor heat treatment apparatus, including: a furnace body, a furnace door, and the above furnace door driving device; and the furnace door driving device is configured to drive the furnace door to rotate to a wafer load port of the furnace body or drive the furnace door to rotate away from the wafer load port of the furnace body, so as to control opening and closing of the wafer load port of the furnace body.

The present disclosure has the following beneficial effects.

The furnace door driving device provided in the embodiment of the present disclosure mainly adopts the connecting disk to connect the driving source and the furnace door, so as to drive the furnace door by the connecting disk to rotate and prevent the rotation of the connecting disk by the limiting assembly and the stop assembly. The connecting disk is provided with the limiting part and the stop part; and the limiting assembly is configured to be in limiting fit with the limiting part when the connecting disk rotates to the preset limit position, so as to stop the connecting disk when the connecting disk rotates to the preset position in the original rotation direction, thereby enabling the furnace door to reach a preset position. Since the kinetic energy of the connecting disk cannot be completely dissipated at the instant of being stopped, the connecting disk rebounds and develops a tendency to rotate reversely. The stop assembly can be in stop fit with the stop part when the limiting assembly is in limiting fit with the limiting part, so as to prevent the connecting disk from rotating in the direction opposite to the original rotation direction. Thus, reverse rotation of the furnace door is prevented, and severe vibration of the connecting disk caused by repeated limiting fit between the connecting disk and the limiting assembly is avoided, thereby avoiding damage to the furnace door caused by excessive vibration of the furnace door.

### BRIEF DESCRIPTION OF DRAWINGS

FIG. 1 is a schematic structural diagram of a furnace door driving device according to an embodiment of the present disclosure;
FIG. 2 is a side view of a furnace door driving device and a furnace door according to an embodiment of the present disclosure;
FIG. 3A is a partial top view of a furnace door driving device according to an embodiment of the present disclosure when rotating in a second rotation direction;
FIG. 3B is a partial top view of a furnace door driving device according to an embodiment of the present disclosure when rotating in a first rotation direction;
FIG. 4 is a partial top view of a hidden rotary motor of a furnace door driving device according to an embodiment of the present disclosure;
FIG. 5 is a bottom view of a connecting disk and a driving source according to an embodiment of the present disclosure;
FIG. 6 is a top view of a furnace door driving device according to an embodiment of the present disclosure;
FIG. 7 is a partial cross-sectional view of a furnace door driving device according to an embodiment of the present disclosure;
FIG. 8 is a block diagram of a semiconductor heat treatment apparatus according to an embodiment of the present disclosure;
FIG. 9 is another block diagram of a semiconductor heat treatment apparatus according to an embodiment of the present disclosure; and
FIG. 10 is a top view of a furnace door driving device and a furnace door according to an embodiment of the present disclosure.

### DETAIL DESCRIPTION OF EMBODIMENTS

In order to enable those of ordinary skill in the art to better understand the technical solutions in the present disclosure, the present disclosure is further described in detail below with reference to the drawings and specific implementations.

It should be understood that the specific embodiments and drawings described herein are just for explaining the present disclosure, rather than limiting the present disclosure.

It should be understood that the embodiments of the present disclosure and the features therein can be combined with each other if no conflict is incurred.

It should be understood that for convenience of description, the drawings of the present disclosure only show the parts related to the embodiments of the present disclosure, and the parts unrelated to the embodiments of the present disclosure are not shown in the drawings.

It should be understood that the functions and steps labelled in the flowcharts and block diagrams of the embodiments of the present disclosure can occur in an order different from that indicated in the drawings if no conflict is incurred.

It should be understood that the above implementations are just exemplary implementations adopted to illustrate the principle of the present disclosure, and the present disclosure is not limited thereto. Various modifications and improvements can be made by those of ordinary sill in the art without departing from the spirit and essence of the present disclosure, and those modifications and improvements are also considered to fall within the scope of the present disclosure.

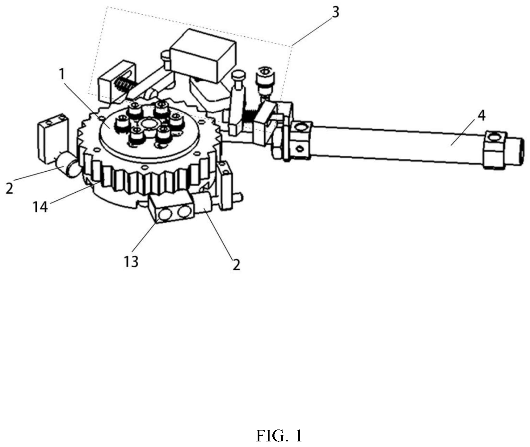

Referring to FIG. 1, the present embodiment provides a furnace door driving device, including: a connecting disk 1, a limiting assembly 2, a stop assembly 3, and a driving source 4.

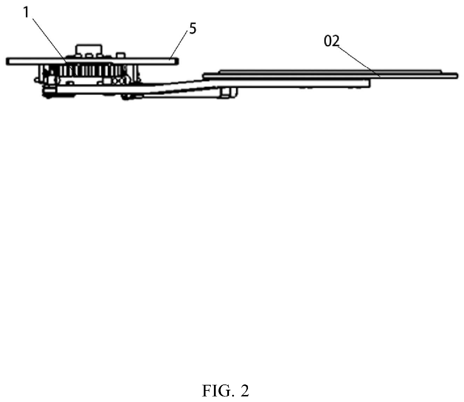

As shown in FIG. 2, the driving source 4 is connected to the connecting disk 1, and the connecting disk 1 is connected to a furnace door 02 of a semiconductor heat treatment apparatus; and the driving source 4 is configured to drive the connecting disk 1 to rotate around an axis of the connecting disk 1, so as to drive the furnace door 02 by the connecting disk 1 to rotate around the axis of the connecting disk 1.

The connecting disk 1 is provided with a limiting part 13 and a stop part 14; a position of the limiting assembly 2 is fixed, and the limiting assembly 2 is configured to be in limiting fit with the limiting part 13 when the connecting disk 1 rotates to a preset limit position, so as to stop the connecting disk 1 from rotating in an original rotation direction, thereby stopping the furnace door 02 from rotating after reaching a preset position. In an embodiment, when the connecting disk 1 rotates in the original rotation direction to the preset limit position, the connecting disk 1 may be stopped by the limiting assembly 2, and since the kinetic energy of the connecting disk 1 cannot be completely dissipated at the instant of mechanic engagement with the limiting assembly 2, the connecting disk 1 may rebound and develop a tendency to rotate reversely.

The stop assembly 3 is configured to be in stop fit with the stop part 14 when the limiting assembly 2 is in limiting fit with the limiting part 13, so as to prevent the connecting disk 1 from rotating in a direction opposite to the original rotation direction. Thus, severe vibration of the connecting disk 1 caused by repeated limiting fit between the connecting disk 1 and the limiting assembly 2 can be avoided, and damage to the furnace door caused by severe vibration of the furnace door can be further avoided.

In some embodiments, the original rotation direction is a first rotation direction or a second rotation direction opposite to the first rotation direction; correspondingly, a reverse rotation direction is the second rotation direction or the first rotation direction.

The stop part 14 includes a gear structure. In an embodiment, the stop assembly 3 is configured to abut against the gear structure when the connecting disk 1 rotates in the second rotation direction, so as to prevent the connecting disk 1 from rotating reversely after being stopped; and the stop assembly 3 is further configured to disengage from the gear structure when the connecting disk 1 rotates in the first rotation direction. Alternatively, the stop assembly 3 is further configured to abut against the gear structure when the connecting disk 1 rotates in the first rotation direction and disengage from the gear structure when the connecting disk 1 rotates in the second rotation direction.

Thus, during the rotation of the connecting disk 1 in the first rotation direction, the stop assembly 3 does not abut against the gear structure before the connecting disk 1 reaches the preset position, without affecting the forward rotation of the connecting disk 1; and when the connecting disk 1 rotates in the first rotation direction to the preset position, the connecting disk 1 develops a tendency to rotate in the second rotation direction because of being stopped by the limiting assembly 2, at this time, the stop assembly 3 may abut against the gear structure to prevent motion of the connecting disk 1 in the second rotation direction, which can prevent the furnace door 02 from rotating reversely and avoid repeated collisions between the connecting disk 1 and the limiting assembly 2, thereby avoiding the damage to the furnace door 02 caused by the severe vibration of the furnace door 02. Similarly, during the rotation of the connecting disk 1 in the second rotation direction, the stop assembly 3 does not abut against the gear structure before the connecting disk 1 reaches the preset position, without affecting the forward rotation of the connecting disk 1; and when the connecting disk 1 rotates to the preset position in the second rotation direction, the stop assembly 3 may abut against the gear structure to prevent motion of the connecting disk 1 in the first rotation direction, which can prevent the furnace door 02 from rotating reversely and avoid repeated collisions between the connecting disk 1 and the limiting assembly 2, thereby avoiding the damage to the furnace door 02 caused by the severe vibration of the furnace door 02.

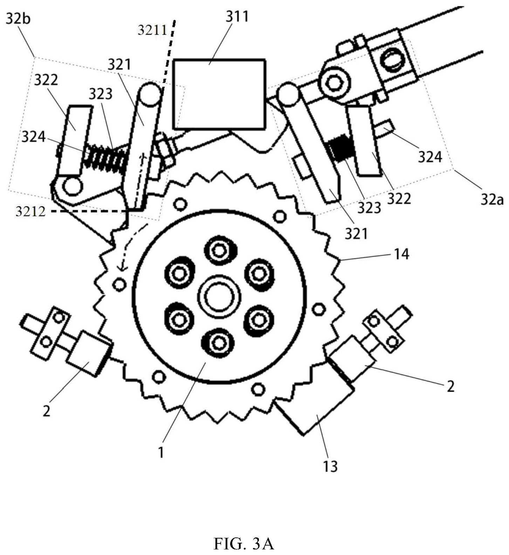

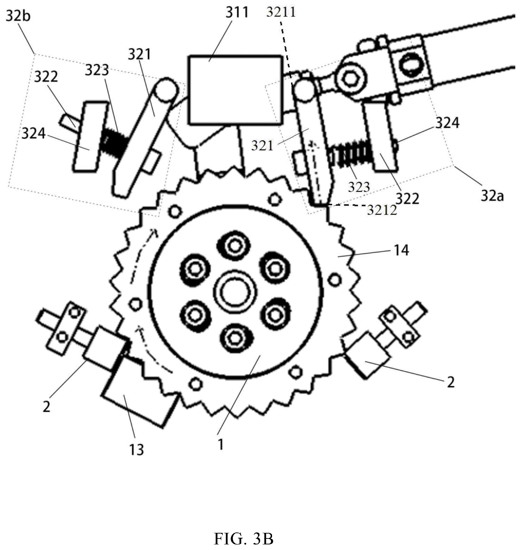

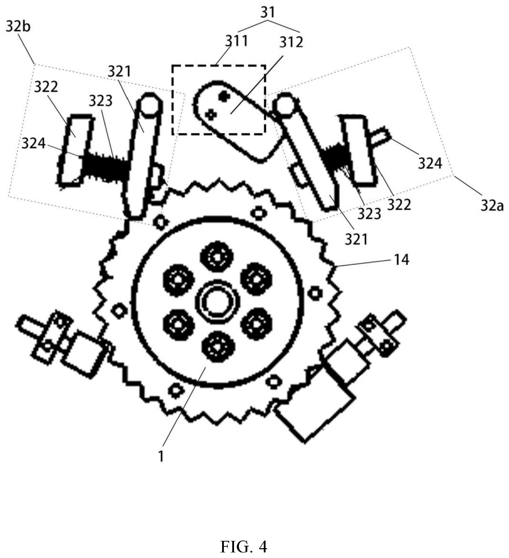

In some embodiments, as shown in FIG. 3A, FIG. 3B, and FIG. 4, the stop assembly 3 includes a switching assembly 31, and a first stop assembly 32a and a second stop assembly 32b which are fixed on a circumferential side of the connecting disk 1. Each of the first stop assembly 32a and the second stop assembly 32b has a stop state and a non-stop state. In an embodiment, the non-stop state is a state in which the first stop assembly 32a or the second stop assembly 32b is away from the gear structure, so as not to contact the stop part 14 to interfere with normal rotation of the stop part 14; and the stop state is a state in which the first stop assembly 32a or the second stop assembly 32b is in driving fit with, i.e., engages with, the gear structure when the connecting disk 1 rotates in the original rotation direction, and abuts against the gear structure when the connecting disk 1 rotates in the direction opposite to the original rotation direction.

Moreover, the switching assembly 31 is configured to switch the first stop assembly 32a to the stop state and switch the second stop assembly 32b to the non-stop state when the connecting disk 1 rotates in the first rotation direction, so as to prevent the connecting disk 1 from rotating in the second rotation direction by the first stop assembly 32a, thereby avoiding reverse rotation of the connecting disk 1 after the rotation of the connecting disk 1 in the first rotation direction is stopped. The switching assembly 31 is further configured to switch the second stop assembly 32b to the stop state and switch the first stop assembly 32a to the non-stop state when the connecting disk 1 rotates in the second rotation direction, so as to prevent the connecting disk 1 from rotating in the first rotation direction by the second stop assembly 32b, thereby avoiding reverse rotation of the connecting disk 1 after the rotation of the connecting disk 1 in the second rotation direction is stopped.

In some embodiments, as shown in FIG. 3A and FIG. 3B, the first stop assembly 32a and the second stop assembly 32b are the same in structure, and are disposed opposite to each other. In an embodiment, each of the first stop assembly 32a and the second stop assembly 32b includes an extendable structure provided with an extendable end 321. The extendable end 321 is kept extended when subjected to no external force, so that the corresponding first stop assembly 32a or second stop assembly 32b is in the stop state.

Moreover, the switching assembly 31 is configured to drive the extendable end 321 of the second stop assembly 32b to retract when the connecting disk 1 rotates in the first rotation direction, so that the extendable end 321 of the second stop assembly 32b is located away from the connecting disk 1, thereby switching the second stop assembly 32b to the non-stop state; and the switching assembly 31 is further configured to drive the extendable end 321 of the first stop assembly 32a to retract when the connecting disk 1 rotates in the second rotation direction, so that the extendable end 321 of the first stop assembly 32a is located away from the connecting disk 1, thereby switching the first stop assembly 32a to the non-stop state.

In some embodiments, as shown in FIG. 3A and FIG. 3B, the extendable ends 321 of the first stop assembly 32a and the second stop assembly 32b are respectively located on two sides of the connecting disk 1, the first stop assembly 32a is located on a side of the connecting disk 1 which points to the first rotation direction, and the second stop assembly 32b is located on a side of the connecting disk 1 which points to the second rotation direction. Taking the furnace door driving device shown in FIG. 3A and FIG. 3B as an example, the first rotation direction is, for example, a clockwise direction, and the second rotation direction is, for example, a counterclockwise direction, then accordingly, the first stop assembly 32a is disposed on the right side of the connecting disk 1, and the second stop assembly 32b is disposed on the left side of the connecting disk 1.

The extendable end 321 of the first stop assembly 32a is capable of extending and retracting in a first linear direction; the first linear direction meets the condition that the gear structure is capable of pushing the extendable end 321 to retract when the connecting disk 1 rotates in the first rotation direction, so as to avoid interference with the normal rotation of the connecting disk 1 in the first rotation direction; and the first linear direction further meets the condition that the extendable end 321 is capable of abutting against a tooth flank of a corresponding gear tooth in the stop part 14 without retracting when the connecting disk 1 rotates in the second rotation direction, so as to prevent the connecting disk 1 from rotating reversely in the second rotation direction.

The extendable end 321 of the second stop assembly 32b is capable of extending and retracting in a second linear direction; the second linear direction meets the condition that the stop part 14 is capable of pushing the extendable end 321 to retract when the connecting disk 1 rotates in the second rotation direction, so as to avoid interference with the normal rotation of the connecting disk 1 in the second rotation direction; and the second linear direction further meets the condition that the extendable end 321 is capable of abutting against a tooth flank of a corresponding gear tooth in the stop part 14 without retracting when the connecting disk 1 rotates in the first rotation direction, so as to prevent the connecting disk 1 from rotating reversely in the first rotation direction.

It should be noted that the "corresponding gear tooth" refers to any gear tooth rotating to a position opposite to the extendable end 321, rather than two specified gear teeth of the gear structure. In an embodiment, taking the extendable end 321 of the second stop assembly 32b shown in FIG. 3A as an example, the extendable end 321 has a first surface 3212 and a second surface 3211 which intersect each other, an included angle between the first surface 3212 and the second surface 3211 is, for example, slightly smaller than an included angle between tooth flanks of two adjacent gear teeth, and in a case where the extendable end 321 abuts against the tooth flank of the corresponding gear tooth in the stop part 14, the first surface 3212 abuts against the tooth flank of the gear tooth adjacent to the first surface 3212. In an embodiment, the included angle between the first surface 3212 and the second surface 3211 is 90° or is appropriately 90°.

Illustratively, as shown in FIG. 3A and FIG. 3B, the first linear direction is, for example, parallel to or substantially parallel to the tooth flank of the gear tooth adjacent to the first surface 3212 of the extendable end 321 of the first stop assembly 32a, and the second linear direction is, for example, parallel to or substantially parallel to the tooth flank of the gear tooth adjacent to the first surface 3212 of the extendable end 321 of the second stop assembly 32b. Thus, when the connecting disk 1 develops the tendency to rotate reversely or already rotates reversely, the first surface 3212 of the extendable end 321 of the first stop assembly 32a or the second stop assembly 32b can apply vertical thrust to the tooth flank of the gear tooth adjacent to the first surface 3212, thereby producing a good stop effect; moreover, slippage between the first surface 3212 and the tooth flank of the gear tooth adjacent to the first surface 3212 is not likely to occur.

Illustratively, in a case where the included angle between the first surface 3212 and the second surface 3211 is 90° or is approximately 90°, the first linear direction is also, for example, perpendicular to or substantially perpendicular to the tooth flank of the gear tooth opposite to the second surface 3211 of the extendable end 321 of the first stop assembly 32a, and the second linear direction is also, for example, perpendicular to or substantially perpendicular to the tooth flank of the gear tooth opposite to the second surface 3211 of the extendable end 321 of the second stop assembly 32b. Thus, when the connecting disk 1 rotates in the first rotation direction or the second rotation direction before reaching the preset position, the extendable end 321 of the first stop assembly 32a or the second stop assembly 32b may be subjected to vertical thrust applied by the tooth flank of the gear tooth adjacent to the second surface 3211 of the extendable end 321 of the first stop assembly 32a or the second stop assembly 32b, so as to retract; meanwhile, relative sliding between the gear tooth and the extendable end 321 occurs as the connecting disk 1 rotates, in other words, the extendable end 321 does not hinder the rotation of the connecting disk 1.

In some embodiments, as shown in FIG. 3A and FIG. 3B, each of the first stop assembly 32a and the second stop assembly 32b further includes a fixed structure 322. The two fixed structures 322 are respectively fixed on the periphery of the connecting disk 1; for example, the two fixed structures 322 are oppositely fixed on two sides of the connecting disk 1. The extendable structure of each of the first stop assembly 32a and the second stop assembly 32b includes a mating block serving as the extendable end 321, a spring 323, and a spring pin 324; one end of the spring pin 324 is fixedly connected to the mating block, and the other end of the spring pin 324 is connected to the fixed structure and is in sliding fit with the fixed structure; and the spring 323 is sleeved on the spring pin 324, and two ends of the spring 323 are respectively connected to the corresponding fixed structure 322 and the corresponding mating block (i.e., the extendable end 321). The spring pin 324 of the first stop assembly 32a extends in the first linear direction to enable the mating block (i.e., the extendable end 321 of the first stop assembly 32a) to extend and retract in the first linear direction; and the spring pin 324 of the second stop assembly 32b extends in the second linear direction to enable the mating block (i.e., the extendable end 321 of the second stop assembly 32b) to extend and retract in the second linear direction.

It should be understood that the spring pin 324 is a rigid structure. When the connecting disk 1 has the tendency to rotate reversely, the first surface 3212 of the extendable end 321 abuts against the tooth flank adjacent thereto, at this time, the spring pin 324 is subjected to lateral thrust, but since the spring pin 324 is a rigid structure, the spring pin 324 does not deform but applies a reaction force opposite to the thrust applied by the tooth flank, thereby preventing the connecting disk 1 from rotating reversely.

Moreover, as described above, the connecting disk 1 has a certain speed, and the kinetic energy of the connecting disk 1 cannot be completely dissipated when the connecting disk 1 collides with the limiting assembly 2. Since the stop assembly 3 may stop the reverse rotation of the connecting disk 1, the residual kinetic energy may be transmitted to the stop assembly 3 and converted into internal energy in the form of vibration. Since the stop assembly 3 in the present embodiment includes the spring 323 having elasticity, the vibration can be eliminated by use of the elasticity of the spring 323, and damage to other rigid parts can be avoided.

In some embodiments, the mating block has the first surface 3212; and the first surface 3212 is parallel to or substantially parallel to an extension direction of the corresponding spring pin 324, and is capable of abutting against the tooth flank of the adjacent gear tooth. Thus, the mating block can apply vertical thrust to the tooth flank of the adjacent gear tooth to prevent the connecting disk 1 from rotating reversely.

In some embodiments, as shown in FIG. 4, the switching assembly 31 includes a rotary motor 311 (as shown by the structure in the dotted box in FIG. 4) and a cam 312. A power output end of the rotary motor 311 is connected to the cam 312 to drive the cam 312 to rotate. The cam 312 is located between the first stop assembly 32a and the second stop assembly 32b; and the cam 312 is configured to push one of the two extendable ends 321 away from the connecting disk 1, that is, to be in the non-stop state, and the other is not subjected to thrust and is kept extended in the stop state. Thus, the first stop assembly 32a and the second stop assembly 32b can be driven by the rotary motor 311 and the cam 312 to switch between the stop state and the non-stop state.

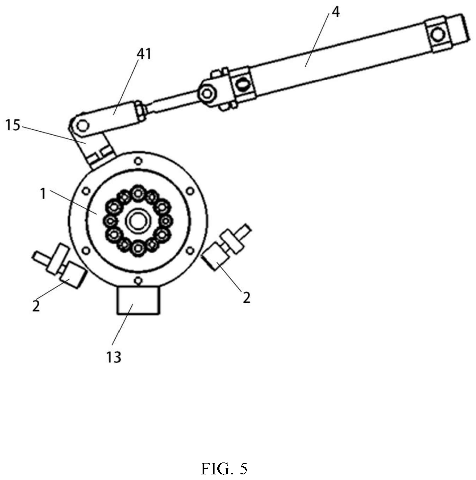

In some embodiments, as shown in FIG. 5, the connecting disk 1 is further provided with a connecting protrusion 15 protruding from an outer circumferential surface thereof. The driving source 4 includes a drive motor, and a position of a main body of the drive motor is fixed relative to the connecting disk 1; and a power output end 41 of the drive motor is hinged to the connecting protrusion 15, and is capable of extending and retracting in a specified direction to drive the connecting disk 1 to rotate in the first rotation direction or the second rotation direction.

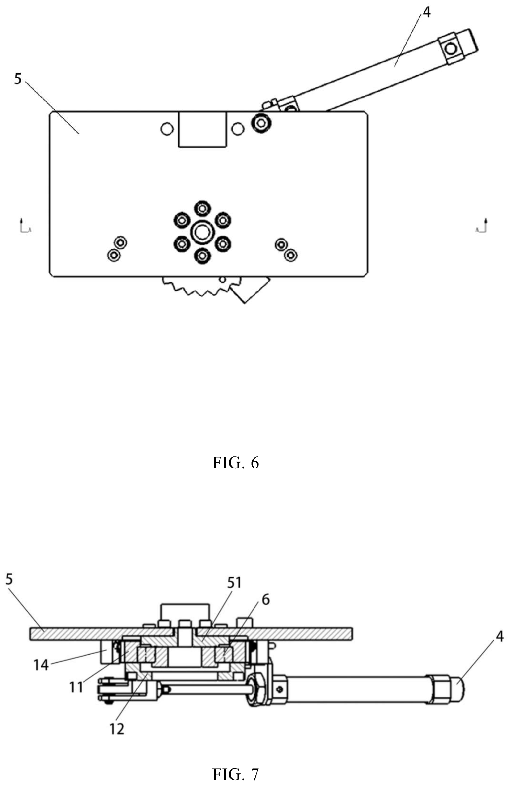

In some embodiments, as shown in FIG. 2 and FIG. 7, the furnace door driving device further includes a stationary disk 5 with a fixed position, and a bearing 6. As shown in FIG. 7, the stationary disk 5 is provided with a bearing support 51 configured to be fixedly connected to an inner ring of the bearing 6.

As shown in FIG. 7, the connecting disk 1 includes a first sub-connecting disk 11 and a second sub-connecting disk 12 coaxially disposed; the gear structure is formed on an outer circumferential side of the first sub-connecting disk 11; the first sub-connecting disk 11 is provided with a bearing mounting hole, the bearing mounting hole is, for example, coaxially disposed with the bearing 6, and the bearing mounting hole is configured to be connected to an outer ring of the bearing 6, so as to ensure a fixed position of an axis of the first sub-connecting disk 11 and enable the first sub-connecting disk 11 to rotate along the axis of the first sub-connecting disk 11, thereby ensuring that the gear structure can rotate along an axis of the gear structure. The second sub-connecting disk 12 is located on a side of the first sub-connecting disk 11 away from the stationary disk 5 and is fixedly connected to the first sub-connecting disk 11; and the limiting part 13 is disposed on an outer circumferential side of the second sub-connecting disk 12 so as not to be in the same layer as the stop part 14, so that the limiting part 13 is prevented from interfering with the first stop assembly 32a or the second stop assembly 32b during the rotation of the connecting disk 1. In an embodiment, the limiting part 13 includes, for example, a limiting protrusion protruding from an outer circumferential surface of the second sub-connecting disk 12.

Accordingly, the limiting assembly 2 for stopping the limiting part 13 is disposed on the circumferential side of the second sub-connecting disk 12, so as not to interfere with the stop part 14 on the outer circumferential side of the first sub-connecting disk 11. The connecting protrusion 15 for being connected to the drive motor is also disposed on the circumferential side of the second sub-connecting disk 12, so as to prevent the power output end of the drive motor from interfering with the stop part 14 and prevent the connecting protrusion 15 from interfering with the stop assembly 3.

In some embodiments, as shown in FIG. 1, the limiting assembly 2 includes, for example, two limiting blocks fixed on the periphery of the connecting disk 1, and the two limiting blocks are respectively configured to stop the limiting part 13 (which includes, for example, the limiting protrusion protruding from the outer circumferential surface of the second sub-connecting disk 12) from continuously moving when the connecting disk 1 rotates to the preset limit positions in the first rotation direction and the second rotation direction, so as to stop the connecting disk 1 from continuously rotating. Accordingly, the number of the preset positions where the connecting disk 1 is stopped is two. The two preset positions may respectively correspond to an open position and a closing position of the furnace door 02, so that the furnace door 02 can be opened and closed by stopping the connecting disk 1 at the two preset positions.

Illustratively, the limiting blocks are made of, for example, a nylon material having good toughness and elasticity, so as to reduce impact caused by collision with the limiting part 13.

In some other embodiments, the stop part 14 is not limited to the gear structure, and may be, for example, formed in the form of a plurality of grooves on an outer circumferential surface of the connecting disk 1. Accordingly, the stop assembly 3 is, for example, an extendable rod capable of being inserted into the groove, and the extendable rod is not connected to the groove during the forward rotation of the connecting disk 1, and is inserted into the groove when the forward rotation of the connecting disk 1 is stopped, thereby preventing the connecting disk 1 from rotating reversely in time.

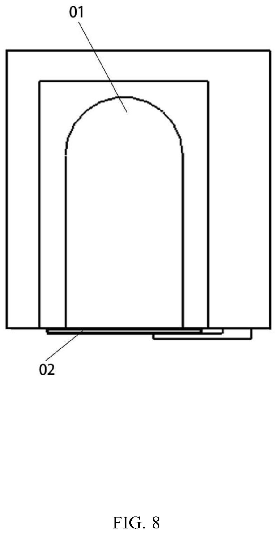

As the other technical solution, the present embodiment further provides a semiconductor heat treatment apparatus, as shown in FIG. 8, which includes: a furnace body 01, a furnace door 02, and the above furnace door driving device. The furnace door driving device is configured to drive the furnace door 02 to rotate to a wafer load port of the furnace body 01 or drive the furnace door 02 to rotate away from the wafer load port of the furnace body 01, so as to control opening and closing of the wafer load port of the furnace body 01.

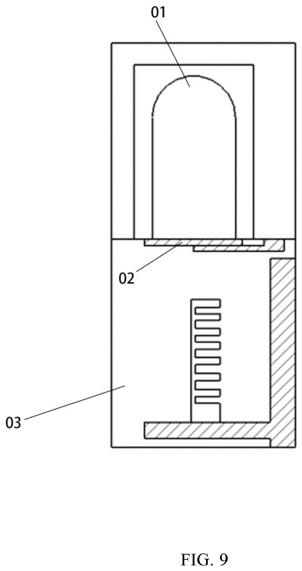

In some embodiments, as shown in FIG. 9, the semiconductor heat treatment apparatus further includes a microenvironment chamber 03 for accommodating a wafer boat which carries a wafer. A boat lifting device is further disposed inside the microenvironment chamber 03 for driving the wafer boat to ascend and descend. The microenvironment chamber 03 is disposed below the furnace body 01, and is capable of communicating with the wafer load port at the bottom of the furnace body 01. Thus, the furnace door 02 disposed at the wafer load port can further function to separate the furnace body 01 from the microenvironment chamber 03, so as to ensure cleanness inside the furnace body 01; moreover, the furnace door 02 can further perform a thermal insulation function, so as to prevent a large amount of heat inside the furnace body 01 from being transferred to the microenvironment chamber 03, and further prevent damage to electrical components inside the microenvironment chamber 03.

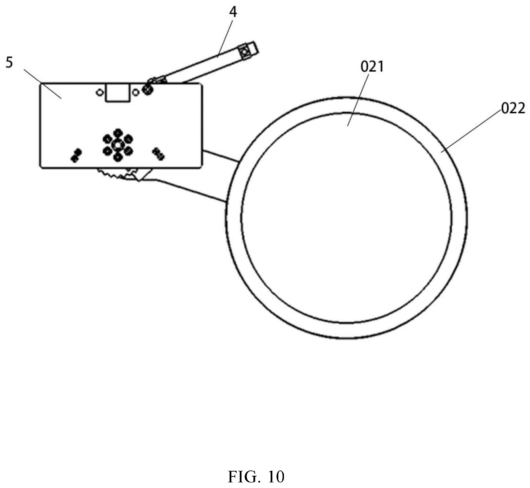

Further, in some embodiments, as shown in FIG. 10, the furnace door 02 includes a quartz disk 021 and a cooling disk 022. The cooling disk 022 is connected to the furnace door driving device, and has a cooling function; and the quartz disk 021 is stacked on a side of the cooling disk 022 close to an inner chamber of the furnace body 01 for thermal insulation between the cooling disk 022 and the furnace body 01.

Moreover, the semiconductor heat treatment apparatus provided in the present embodiment adopts the above furnace door driving device, and the furnace door 02 can be prevented from rotating reversely when rotating to preset positions, so as not to vibrate severely. Therefore, the semiconductor heat treatment apparatus provided in the present embodiment can avoid damage to the furnace door 02 caused by severe vibration, thereby avoiding the problems of breakage of the quartz disk 021 and damage to parts inside the cooling disk 022.

It should be understood that the above implementations are just exemplary implementations adopted to illustrate the principle of the present disclosure, and the present disclosure is not limited thereto. Various modifications and improvements can be made by those of ordinary sill in the art without departing from the spirit and essence of the present disclosure, and those modifications and improvements are also considered to fall within the scope of the present disclosure.

## Claims

1. A furnace door driving device for a semiconductor heat treatment apparatus, the furnace door driving device being configured to drive a furnace door of the semiconductor heat treatment apparatus to rotate, wherein the furnace door driving device comprises: a connecting disk, a limiting assembly, a stop assembly, and a driving source;
the driving source is connected to the connecting disk, and is configured to drive the connecting disk to rotate around an axis of the connecting disk;
the connecting disk is connected to the furnace door, and is configured to drive the furnace door to rotate; the connecting disk is provided with a limiting part and a stop part; and the limiting assembly is configured to be in limiting fit with the limiting part when the connecting disk rotates to a preset limit position, so as to stop the connecting disk from rotating continuously in an original rotation direction; and
the stop assembly is configured to be in stop fit with the stop part when the limiting assembly is in limiting fit with the limiting part, so as to prevent the connecting disk from rotating in a direction opposite to the original rotation direction.

2. The furnace door driving device of claim 1, wherein the original rotation direction is a first rotation direction or a second rotation direction opposite to the first rotation direction;
the stop part comprises a gear structure; and
the stop assembly is configured to abut against the gear structure when the connecting disk rotates in the second rotation direction, and disengage from the gear structure when the connecting disk rotates in the first rotation direction; or, the stop assembly is configured to abut against the gear structure when the connecting disk rotates in the first rotation direction, and disengage from the gear structure when the connecting disk rotates in the second rotation direction.

3. The furnace door driving device of claim 2, wherein the stop assembly comprises a switching assembly, and a first stop assembly and a second stop assembly which are fixed on the periphery of the connecting disk; wherein
the switching assembly is configured to switch the first stop assembly to a stop state and switch the second stop assembly to a non-stop state when the connecting disk rotates in the first rotation direction, and is further configured to switch the second stop assembly to the stop state and switch the first stop assembly to the non-stop state when the connecting disk rotates in the second rotation direction;
wherein the non-stop state is a state in which the first stop assembly or the second stop assembly is away from the gear structure; and the stop state is a state in which the first stop assembly or the second stop assembly is in driving fit with the gear structure when the connecting disk rotates in the original rotation direction, and abuts against the gear structure when the connecting disk rotates in the direction opposite to the original rotation direction.

4. The furnace door driving device of claim 3, wherein each of the first stop assembly and the second stop assembly comprises: an extendable structure, which is provided with an extendable end;
the extendable end is kept extended when subjected to no external force, so as to keep the corresponding first stop assembly or the corresponding second stop assembly in the stop state; and
the switching assembly is configured to drive the extendable end of the second stop assembly to retract to a position away from the connecting disk when the connecting disk rotates in the first rotation direction, so as to switch the second stop assembly to the non-stop state; and the switching assembly is further configured to drive the extendable end of the first stop assembly to retract a position away from the connecting disk when the connecting disk rotates in the second rotation direction, so as to switch the first stop assembly to the non-stop state.

5. The furnace door driving device of claim 4, wherein the extendable end of the first stop assembly and the extendable end of the second stop assembly are located on two sides of the connecting disk, respectively;
the extendable end of the first stop assembly is capable of extending and retracting in a first linear direction; and the first linear direction meets the condition that the gear structure is capable of pushing the extendable end to retract when the connecting disk rotates in the first rotation direction and abutting against a tooth flank of a corresponding gear tooth in the gear structure when the connecting disk rotates in the second rotation direction; and
the extendable end of the second stop assembly is capable of extending and retracting in a second linear direction; and the second linear direction meets the condition that the gear structure is capable of pushing the extendable end to retract when the connecting disk rotates in the second rotation direction and abutting against a tooth flank of a corresponding gear tooth in the gear structure when the connecting disk rotates in the first rotation direction.

6. The furnace door driving device of claim 5, wherein each of the first stop assembly and the second stop assembly further comprises a fixed structure; and two fixed structures are respectively fixed on the periphery of the connecting disk;
the extendable structure further comprises a mating block serving as the extendable end, a spring, and a spring pin;
the spring pin of the first stop assembly extends in the first linear direction; the spring pin of the second stop assembly extends in the second linear direction; and one end of the spring pin is fixedly connected to the mating block, and the other end of the spring pin is connected to the fixed structure and is in sliding fit with the fixed structure; and
the spring is sleeved on the spring pin, and two ends of the spring are connected to the corresponding fixed structure and the corresponding mating block, respectively.

7. The furnace door driving device of claim 6, wherein the mating block has a first surface; and the first surface is parallel to an extension direction of the corresponding spring pin, and is capable of abutting against a tooth flank of an adjacent gear tooth.

8. The furnace door driving device of claim 2, wherein the limiting part comprises a limiting protrusion, which protrudes from an outer circumferential surface of the connecting disk; and
the limiting assembly comprises two limiting blocks, which are fixed on the periphery of the connecting disk, and the two limiting blocks are respectively configured to stop the limiting protrusion from continuously moving when the connecting disk rotates to preset limit positions in the first rotation direction and the second rotation direction, so as to stop the connecting disk from continuously rotating.

9. The furnace door driving device of claim 4, wherein the switching assembly comprises a rotary motor and a cam; and a power output end of the rotary motor is connected to the cam, and is configured to drive the cam to rotate; and
the cam is located between the first stop assembly and the second stop assembly; and the cam is configured to push one of two extendable ends away from the connecting disk, so as to drive the first stop assembly or the second stop assembly to switch to the non-stop state.

10. The furnace door driving device of claim 2, further comprising a stationary disk with a fixed position, and a bearing; wherein the stationary disk is provided with a bearing support, which is configured to be fixedly connected to an inner ring of the bearing;
the connecting disk comprises a first sub-connecting disk and a second sub-connecting disk coaxially disposed; the gear structure is formed on an outer circumferential side of the first sub-connecting disk; and the first sub-connecting disk is provided with a bearing mounting hole, which is configured to be connected to an outer ring of the bearing; and
the second sub-connecting disk is located on a side of the first sub-connecting disk away from the stationary disk, and is fixedly connected to the first sub-connecting disk; and the limiting part is disposed on an outer circumferential side of the second sub-connecting disk.

11. A semiconductor heat treatment apparatus, comprising: a furnace body, a furnace door, and the furnace door driving device of any one of claims 1 to 10; wherein the furnace door driving device is configured to drive the furnace door to rotate to a wafer load port of the furnace body or drive the furnace door to rotate away from the wafer load port of the furnace body, so as to control opening and closing of the wafer load port of the furnace body.
